# EUROPÄISCHE PATENTSCHRIFT

(11) **EP 3 911 961 B1**
(45) Veröffentlichungstag und Bekanntmachung des Hinweises auf die Patenterteilung: **20.08.2025**
(21) Anmeldenummer: 20700586.9
(22) Anmeldetag: 13.01.2020
(51) Int. Cl.: G01R 1/073, G01R 31/28

(54) **VORRICHTUNG ZUM PRÜFEN VON BAUTEILEN UNTER ERHÖHTEM GASDRUCK**
DEVICE FOR TESTING COMPONENTS UNDER ELEVATED GAS PRESSURE
DISPOSITIF DE CONTRÔLE DE PIÈCES SOUS PRESSION GAZEUSE ÉLEVÉE

(30) Priorität: 14.01.2019 AT 102019
(43) Veröffentlichungstag der Anmeldung: 24.11.2021
(73) Patentinhaber: Gaggl, Rainer, 9580 Drobollach (AT)
(72) Erfinder: Gaggl, Rainer, 9580 Drobollach (AT)
(74) Vertreter: Beer & Partner Patentanwälte KG
(86) Internationale Anmeldenummer: PCT/EP2020/050673
(87) Internationale Veröffentlichungsnummer: WO 2020/148226

(56) Entgegenhaltungen:
- EP-A1- 2 824 467
- AT-U1- 14 210
- JP-A- 2018 160 592

## Beschreibung

Die Erfindung betrifft eine Vorrichtung zum Prüfen von elektrischen/elektronischen Bauteilen unter erhöhtem Gasdruck mit den Merkmalen des Oberbegriffes von Patentanspruch 1.

Derartige Vorrichtungen sind bekannt.

Beispielsweise zeigt AT 14209 U1 eine Vorrichtung zum Prüfen von Halbleiterbauelementen, bei der eine Nadelkarte eine Druckkammer trägt. Die Druckkammer ist auf ihrem einem zu prüfenden Haltleiterbauelement zugeordneten, offenen Ende durch einen beweglichen Dichtring begrenzt. Der Dichtring wird auf Grund des Bernoulli-Effektes, der durch Druckgas, das aus der Druckkammer durch den Spalt zwischen Dichtring und Halbleiterbauelement strömt, entsteht, in definiertem Abstand vom Halbleiterbauelement gehalten.

Bei der aus AT 14 209 U1 und aus AT 14 210 U1 bekannten Vorrichtungen strömt das Gas weitgehend ungehindert über einen Spalt aus.

Eine Vorrichtung zum Vermeiden von Funkenüberschlägen beim Hochspannungsprüfen von Halbleiterbauelementen (Chips) auf Halbleiterscheiben ist aus AT 511 226 B1 bekannt. Die bekannte Vorrichtung umfasst eine der Halbleiterscheibe dichtend zustellbare Druckkammer mit einer Druckgaszuführung, sodass der Innenraum der Druckkammer unter Überdruck gesetzt und so die Zündspannung für einen Funkenüberschlag zwischen Kontaktflächen höher ist als die maximal anzulegende Prüfspannung. Die Druckkammer ist mit einer Nadelkarte mit Kontaktnadeln verbunden. Die Druckkammer besitzt einen beweglichen Teil, der relativ zu den der Nadelkarte verbundenen Teilen der Druckkammer beweglich ist. Der als Ringdichtung ausgebildete bewegliche Teil der Druckkammer wird durch ein Luftlager im Spalt zwischen der Druckkammer und der Halbleiterscheibe dichtend im Abstand von der Oberfläche der Halbleiterscheibe gehalten, wobei zwischen dem mit der Nadelkarte verbundenen Teil der Druckkammer und dem beweglichen Teil der Druckkammer wenigstens eine Feder vorgesehen ist.

Aus AT 511 058 B1 sind ein Verfahren und eine Vorrichtung zum Prüfen von Drucksensoren, insbesondere Drucksensorchips, einer Halbleiterscheibe bekannt. Zum elektrischen und pneumatischen Prüfen von Drucksensoren, insbesondere Drucksensorchips, einer Halbleiterscheibe wird die Halbleiterscheibe elektrisch kontaktiert und in einer Druckkammer unter einen definierten Überdruck gesetzt, wobei der die Halbleiterscheibe belastende Überdruck durch einen Referenzdrucksensor erfasst wird. Die Druckkammer ist an einer Nadelkarte mit Prüfnadeln angeordnet und weist einen Teil auf, der relativ zur Nadelkarte bewegt werden kann. Zwischen der der Halbleiterscheibe zugekehrten Stirnfläche des beweglichen Teils der Druckkammer und der Halbleiterscheibe wird ein Luftlager ausgebildet. Das bekannte Verfahren erlaubt es, Drucksensorchips einer Halbleiterscheibe unter definierten Bedingungen zu prüfen, wobei das Prüfen nicht nur bei einem definierten Druck, sondern auch bei im akustischen Bereich liegenden Druckschwankungen möglich ist.

Mit Prüfnadeln ausgestattete Vorrichtungen zum Prüfen von Halbleiterbauteilen, wobei die Vorrichtungen Druckkammern aufweisen, sind bekannt.

So beschreibt EP 2 824 467 A1 eine gattungsgemäße Prüfvorrichtung mit Nadeln und einer Druckkammer, wobei eine Einrichtung zum Verhindern von Funkenbildung (Lichtbogenbildung) vorgesehen ist. Diese Einrichtung umfasst einen ringförmigen Vorsprung (Fig. 9), der aus Isolierwerkstoff (Kunstharz) bestehen soll. Irgendein Hinweis auf Fasern ist der EP 2 824 467 A1 nicht zu entnehmen. Bei der aus EP 2 824 467 A1 bekannten Prüfvorrichtung liegt zwischen dem zu prüfenden Bauteil und einer seitlichen Begrenzung der Druckkammer ein Spalt, der als Labyrinthdichtung wirkt, vor.

JP 2018160591 A1 zeigt und beschreibt eine Druckkammer für eine Prüfvorrichtung mit beweglichem Ring, wobei Gas aus der Druckkammer über einen Spalt ausströmt. JP 2018160591 A1 ist kein Hinweis auf Fasern zu entnehmen.

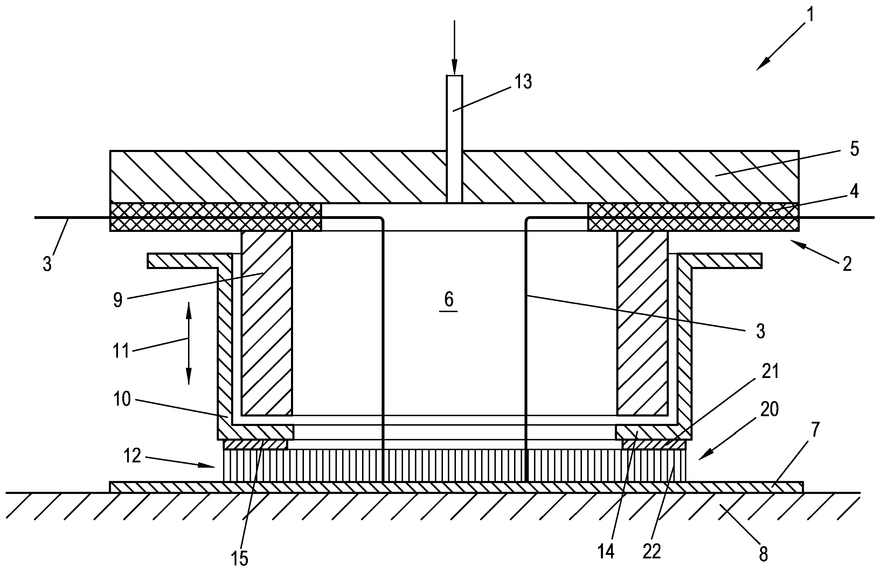

US 2012/0074976 A1 betrifft eine Anlage zum Prüfen von Wafern, wobei eine Vakuumprüfkammer vorgesehen ist, die seitlich durch einen Dichtungsring begrenzt ist. Auch der "vacuum chuck" für das Handhaben der Wafer, um diese von und zur Prüfvorrichtung zu bewegen, umfasst einen Dichtungsring, wie dies z.B. in Fig. 4b gezeigt ist. Die in Fig. 4b im unteren Bereich des "chuck" vorgesehenen, schrägen Linien sind in der Beschreibung nicht erwähnt, so dass davon auszugehen ist, dass dies keine Fasern sind, welche eine Druckkammer seitlich begrenzen.

Problematisch bei den bekannten Vorrichtungen der eingangs genannten Gattung ist es, dass durch den Spalt zwischen der Vorrichtung und dem zu prüfenden Bauteil Gas aus der Druckkammer austritt, so dass es nicht einfach ist, den gewünschten, erhöhten Druck in der Druckkammer aufrecht zu halten.

Ein weiterer Nachteil besteht darin, dass sich feste Teilchen (Partikel) in den Spalt bewegen können und dort den zu prüfenden Bauteil, beispielsweise durch Zerkratzen, beschädigen. Besonders störend ist es, wenn sich feste Partikel beim In-Stellung-Bringen der Vorrichtung in dem Spalt befinden und sich in den zu prüfenden Bauteil und/oder in die Stirnfläche eines die Druckkammer seitlich ringförmigen begrenzenden Teils eingraben und an dem Teil festhaften.

Der Erfindung liegt die Aufgabe zugrunde, die bekannten Vorrichtungen dahingehend zu verbessern, dass die geschilderten Probleme vermieden sind.

Gelöst wird diese Aufgabe erfindungsgemäß mit einer Vorrichtung, die die Merkmale von Anspruch 1 aufweist.

Bevorzugte und vorteilhafte Ausgestaltungen der erfindungsgemäßen Vorrichtung sind Gegenstand der Unteransprüche.

Da bei der erfindungsgemäßen Vorrichtung an der dem zu prüfenden Bauteil zugewandten Stirnfläche der seitlichen Begrenzung der Druckkammer, beispielsweise eines Ringes oder eines ringförmigen Teils, der die Druckkammer seitlich begrenzt, Fasern vorgesehen sind, wird verhindert, dass feste Partikel in den Spalt eintreten können.

Zusätzlich ergibt sich bei der erfindungsgemäßen Vorrichtung der Vorteil, dass durch die Fasern das Abströmen von Gas aus der Druckkammer behindert wird.

In einer bevorzugten Ausführungsform der Erfindung sind die Fasern zur Ebene der Stirnfläche der seitlichen Begrenzung der Druckkammer, insbesondere des Ringes oder des ringförmigen, die Druckkammer begrenzenden Teils, im Wesentlichen senkrecht ausgerichtet und in einer Ausführungsform, die nicht vom Wortlaut der Ansprüche abgedeckt ist, Bestandteile eines samtartigen Belages, der an der Stirnfläche der seitlichen Begrenzung der Druckkammer angeordnet (befestigt) ist.

Weitere Einzelheiten und Merkmale der erfindungsgemäßen Vorrichtung ergeben sich aus der nachstehenden Beschreibung eines in der angeschlossenen Zeichnung schematisch und im Schnitt dargestellten Ausführungsbeispiels.

Eine Vorrichtung 1 zum Prüfen von elektrischen und/oder elektronischen Bauteilen, wie beispielsweise Leiterbauelementen, insbesondere in Form von Wafern mit Chips oder von Drucksensoren, insbesondere Drucksensorchips, die an einer Halbleiterscheibe vorgesehen sind, umfasst eine Nadelkarte 2 mit Prüfnadeln 3, die in einer an einer Grundplatte 5 der Nadelkarte 2 vorgesehenen Kunststoffmasse 4 eingebettet sind.

Die Vorrichtung 1 umfasst eine Druckkammer 6, die auf der vom zu prüfenden Bauteil 7, der auf einem Träger 8 aufliegt, abgewandten Seite von der Grundplatte 5 begrenzt wird. Die seitliche Begrenzung der Druckkammer 6 wird von einem Ring 9 gebildet. An dem Ring 9 ist außen ein ringförmiger Teil 10 ("Dichtring") vorgesehen. Der ringförmige Teil 10 ist in Richtung des Doppelpfeiles 11 gegenüber dem Ring 9 beweglich (verschiebbar). Die Führung des ringförmigen Teils 10 an dem Ring 9 kann im Prinzip so ausgebildet sein, wie dies aus AT 511 058 B1 oder AT 511 226 B1 bekannt ist.

Durch über eine Leitung 13 in die Druckkammer 6 eingeführtes Gas wird nicht nur in der Druckkammer 6 ein erhöhter Druck erzeugt, sondern auch in dem Spalt 12 zwischen dem zu prüfenden Bauteil 7 und einem nach innen (in Richtung auf die Druckkammer 6 hin) weisenden (flanschartigen) Ringteil 14 des beweglichen, ringförmigen Teils 10 ein Gaslager ausgebildet.

An der dem zu prüfenden Bauteil 7 zugewandten Stirnfläche 15 des Ringteils 14 des beweglichen, ringförmigen Teils 10 ist ein samtartiger Belag 20, der beispielsweise ringförmig sein kann, vorgesehen. Der samtartige Belag 20, der beispielsweise die ganze (ringförmige) Stirnfläche 15 des Ringteils 14 des ringförmigen Teils 10 bedeckt, umfasst einen Tragebereich 21 und Fasern 22, die im Wesentlichen senkrecht zu dem zu prüfenden Bauteil 7 einerseits und der Stirnfläche 15 des ringförmigen Teils 10 anderseits ausgerichtet sind. Wie aus der schematischen Zeichnungsfigur erkennbar, erstrecken sich die Fasern 22 bis zu der der Vorrichtung 1 zugewandten Fläche des zu prüfenden Bauteils 7.

Wenngleich die Erfindung anhand eines Ausführungsbeispiels mit einem ringförmigen Teil 10, der an dem die Druckkammer 6 seitlich begrenzenden Ring 9 beweglich angeordnet ist, beschrieben worden ist, ist dieser bewegliche, ringförmige Teil 10 nicht zwingend vorgesehen.

Weiters ist eine Ausführungsform der erfindungsgemäßen Vorrichtung in Betracht gezogen, bei der der ringförmige Teil 10 gegenüber dem die Druckkammer 6 seitlich begrenzenden Ring 9 nicht beweglich, also an dem Ring 9 fest und nicht verschiebbar, angeordnet ist.

Wenn der ringförmige Teil 10 nicht beweglich ist, kann der ringförmige Teil 10 mit dem Ring 9 auch einteilig ausgeführt sein.

Bei Ausführungsformen ohne den beweglichen, ringförmigen Teil 10 sind die Fasern 22 an der dem zu prüfenden Bauteil 7 zugekehrten Stirnfläche des Ringes 9 vorgesehen.

Wenn der ringförmige Teil 10 nicht beweglich oder mit dem Ring 9 nicht einstückig ausgebildet ist, liegt in dem Spalt 12 kein Gaslager vor.

Durch eine dichte Anordnung der Fasern 22 des samtartigen Belages 20 wird erreicht, dass das Ausströmen von Gas, das über die Leitung 13 der Druckkammer 6 zugeführt wird, durch den Spalt 12 behindert wird, sodass das Aufbauen von Druck in der Druckkammer 6 ohne großen Gasverlust möglich ist.

Zusätzlich verhindern die Fasern 22, dass feste Partikel in den Spalt 12 zwischen Vorrichtung 1 und zu prüfenden Bauteil 7 (Halbleiterscheibe) eindringen und dort die eingangs geschilderten Beschädigungen verursachen.

Ein weiterer vorteilhafter Effekt der erfindungsgemäßen Vorrichtung besteht auch in Folgendem: Falls (kleinere) Partikel in den Spalt 12 eindringen sollten, können diese Partikel zwischen Fasern 22 gleiten und werden von Fasern 22 so gehalten, dass sie keinen Druck auf den zu prüfenden Bauteil 7 (Prüfling) ausüben.

In einer bevorzugten Ausführungsform haben die Fasern 22 eine Länge, die der Größe des Spaltes 12 entspricht, beispielsweise eine Länge zwischen 300 und 500 Mikrometern.

Zusammenfassend kann ein Ausführungsbeispiel der Erfindung wie folgt beschrieben werden:
In einer Vorrichtung 1 zum Prüfen von Bauteilen unter erhöhtem Druck ist eine Druckkammer 6 vorgesehen, wobei die seitliche Begrenzung der Druckkammer 6 einen Ring 9 und ringförmigen Teil 10, der senkrecht zur Ebene des zu prüfenden Bauteils 7 beweglich sei kann, aufweist. An der dem zu prüfenden Bauteil 7 zugewandten Stirnfläche 15 des ringförmigen Teils 10 oder des Ringes 9 ist ein samtartiger Belag 20 vorgesehen, dessen Fasern 22 vom ringförmigen Teil 10 oder vom Ring 9 in Richtung auf den zu prüfenden Bauteil 7 ragen und den Spalt 12 zwischen der Vorrichtung 1 und dem Bauteil 7 überbrücken.

## Patentansprüche

1. Vorrichtung (1) zum Prüfen von elektrischen/elektronischen Bauteilen (7) unter erhöhtem Gasdruck mit einer Druckkammer (6), die an einer Nadelkarte (2) mit Prüfnadeln (3) vorgesehen ist, wobei eine seitliche Begrenzung der Druckkammer (6), die wenigstens einen Ring (9) aufweist, vorgesehen ist und wobei zwischen dem zu prüfenden Bauteil (7) und der seitlichen Begrenzung der Druckkammer (6) ein Spalt (12) vorliegt, **dadurch gekennzeichnet, dass** an der dem zu prüfenden Bauteil (7) zugewandten Stirnfläche der seitlichen Begrenzung der Druckkammer (6) Fasern (22) vorgesehen sind und dass die Fasern (22) die Strömung von Gas aus der Druckkammer (6) behindernd angeordnet sind.

2. Vorrichtung nach Anspruch 1, **dadurch gekennzeichnet, dass** die Fasern (22) zur Ebene der Stirnfläche der seitlichen Begrenzung der Druckkammer, insbesondere des Ringes (9), im Wesentlichen senkrecht ausgerichtet sind.

3. Vorrichtung nach Anspruch 1 oder 2, **dadurch gekennzeichnet, dass** die Fasern (22) eine Länge zwischen 300 und 500 Mikrometern haben.

4. Vorrichtung nach einem der Ansprüche 1 bis 3, **dadurch gekennzeichnet, dass** die freien, von der seitlichen Begrenzung der Druckkammer (6), insbesondere vom Ring (9), entfernt liegenden Enden der Fasern (22) an dem zu prüfenden Bauteil (7) anliegen.

5. Vorrichtung nach einem der Ansprüche 1 bis 4, **dadurch gekennzeichnet, dass** an dem Ring (9) auf dessen von der Druckkammer (6) abgewandten Seite ein ringförmiger Teil (10), der gegebenenfalls einen nach innen weisenden Ringteil (14) aufweist, vorgesehen ist.

6. Vorrichtung nach Anspruch 5, **dadurch gekennzeichnet, dass** der ringförmige Teil (10) an dem Ring (9) relativ zur Nadelkarte (2) beweglich geführt ist.

7. Vorrichtung nach Anspruch 5, **dadurch gekennzeichnet, dass** der ringförmige Teil (10) an dem Ring (9) festgelegt und vorzugsweise mit dem Ring (9) einstückig ausgebildet ist.

8. Vorrichtung nach einem der Ansprüche 5 bis 7, **dadurch gekennzeichnet, dass** die Fasern (22) an dem ringförmigen Teil (10) angeordnet sind.

9. Vorrichtung nach einem der Ansprüche 5 bis 8, **dadurch gekennzeichnet, dass** die Fasern (22) an der dem zu prüfenden Bauteil (7) zugewandten Stirnfläche (15) des Ringteils (14) des ringförmigen Teils (10) angeordnet sind.

10. Vorrichtung nach einem der Ansprüche 1 bis 9, **dadurch gekennzeichnet, dass** die Vorrichtung (1) zum pneumatischen Prüfen von Bauteilen (7), welche Drucksensoren, insbesondere Drucksensorchips, einer Halbleiterscheibe sind, eingerichtet ist.

11. Vorrichtung nach einem der Ansprüche 1 bis 10, **dadurch gekennzeichnet, dass** die Vorrichtung (1) zum elektrischen Prüfen von Bauteilen (7), welche Halbleiterbauelemente sind, eingerichtet ist.

## Claims

1. Device (1) for testing electrical/electronic components (7) under elevated gas pressure with a pressure chamber (6), which is provided with test needles (3) on a needle card (2), wherein a lateral boundary of the pressure chamber (6), which has at least one ring (9), is provided, and wherein there is a gap (12) between the component (7) that is to be tested and the lateral boundary of the pressure chamber (6), **characterized in that** fibers (22) are provided on the end face of the lateral boundary of the pressure chamber (6) facing the component (7) that is to be tested, and **in that** the fibers (22) are arranged to impede the flow of gas from the pressure chamber (6).

2. Device according to claim 1, **characterized in that** the fibers (22) are oriented substantially perpendicular to the plane of the end face of the lateral boundary of the pressure chamber, in particular of the ring (9).

3. Device according to claim 1 or 2, **characterized in that** the fibers (22) have a length between 300 and 500 micrometers.

4. Device according to one of claims 1 to 3, **characterized in that** the free ends of the fibers (22), which are located remote from the lateral boundary of the pressure chamber (6), in particular from the ring (9), rest against the component (7) to be tested.

5. Device according to one of claims 1 to 4, **characterized in that** a ring-shaped part (10), which may have an inwardly facing ring part (14), is provided on the ring (9) on its side facing away from the pressure chamber (6).

6. Device according to claim 5, **characterized in that** the ring-shaped part (10) is guided on the ring (9) so as to be movable relative to the needle card (2).

7. Device according to claim 5, **characterized in that** the ring-shaped part (10) is fixed to the ring (9) and is preferably formed integrally with the ring (9).

8. Device according to one of claims 5 to 7, **characterized in that** the fibers (22) are arranged on the ring-shaped part (10).

9. Device according to one of claims 5 to 8, **characterized in that** the fibers (22) are arranged on the end face (15) of the ring part (14) of the ring-shaped part (10) facing the component (7) to be tested.

10. Device according to one of claims 1 to 9, **characterized in that** the device (1) is designed for pneumatically testing components (7) which are pressure sensors, in particular pressure sensor chips, of a semiconductor wafer.

11. Device according to one of claims 1 to 10, **characterized in that** the device (1) is designed for electrically testing components (7) which are semiconductor components.

## Revendications

1. Dispositif (1) pour le contrôle de composants électriques/électroniques (7) sous une pression de gaz augmentée avec une chambre sous pression (6) qui est prévue sur une carte à aiguilles (2) munie d'aiguilles de contrôle (3), dans lequel est prévue une délimitation latérale de la chambre sous pression (6) présentant au moins un anneau (9) et dans lequel un interstice (12) est formé entre le composant (7) à contrôler et la délimitation latérale de la chambre sous pression (6), **caractérisé en ce que** des fibres (22) sont prévues sur la face d'extrémité de la délimitation latérale de la chambre sous pression (6) tournée vers le composant (7) à contrôler et **en ce que** les fibres (22) sont disposées de façon à empêcher l'écoulement de gaz hors de la chambre sous pression (6).

2. Dispositif selon la revendication 1, **caractérisé en ce que** les fibres (22) sont orientées de façon sensiblement perpendiculaire au plan de la face d'extrémité de la délimitation latérale de la chambre sous pression, en particulier de l'anneau (9).

3. Dispositif selon la revendication 1 ou 2, **caractérisé en ce que** les fibres (22) ont une longueur de 300 à 500 micromètres.

4. Dispositif selon l'une des revendications 1 à 3, **caractérisé en ce que** les extrémités libres des fibres (22) situées à distance de la délimitation latérale de la chambre sous pression (6), en particulier de l'anneau (9), s'appliquent sur le composant (7) à contrôler.

5. Dispositif selon l'une des revendications 1 à 4, **caractérisé en ce qu'**une partie annulaire (10), présentant éventuellement une partie en anneau (14) tournée vers l'intérieur, est prévue sur l'anneau (9) sur le côté de celui-ci opposé à la chambre sous pression (6).

6. Dispositif selon la revendication 5, **caractérisé en ce que** la partie annulaire (10) est guidée sur l'anneau (9) dans un mouvement par rapport à la carte à aiguilles (2).

7. Dispositif selon la revendication 5, **caractérisé en ce que** la partie annulaire (10) est fixée sur l'anneau (9) et de préférence formée d'une pièce avec l'anneau (9).

8. Dispositif selon l'une des revendications 5 à 7, **caractérisé en ce que** les fibres (22) sont disposées sur la partie annulaire (10).

9. Dispositif selon l'une des revendications 5 à 8, **caractérisé en ce que** les fibres (22) sont disposées sur la surface d'extrémité (15) de la partie annulaire (10) tournée vers le composant (7) à contrôler.

10. Dispositif selon l'une des revendications 1 à 9, **caractérisé en ce que** le dispositif (1) est agencé pour l'essai pneumatique de composants (7) qui sont des capteurs de pression, en particulier des puces de capteur de pression, d'une plaquette de semiconducteurs.

11. Dispositif selon l'une des revendications 1 à 10, **caractérisé en ce que** le dispositif (1) est agencé pour l'essai électrique de composants (7) qui sont des composants semiconducteurs.
